Europäisches Patentamt

European Patent Office

Office européen des brevets

(19)

(11) EP 0 506 708 B1

(12) **EUROPEAN PATENT SPECIFICATION**

(45) Date of publication and mention
of the grant of the patent:
**17.07.1996 Bulletin 1996/29**

(21) Application number: **91900439.0**

(22) Date of filing: **26.11.1990**

(51) Int Cl.6: **H04B 15/00**

(86) International application number:
**PCT/US90/06784**

(87) International publication number:
**WO 91/08624 (13.06.1991 Gazette 1991/13)**

(54) **METHOD AND APPARATUS FOR RANDOM FM NOISE CANCELLATION**

VERFAHREN UND GERÄT ZUR STATISTISCHEN FM-RAUSCHUNTERDRÜCKUNG

PROCEDE ET APPAREIL D'ANNULATION ALEATOIRE DE BRUIT DE MODULATION DE
FREQUENCE

(84) Designated Contracting States:
**DE FR GB**

(30) Priority: **30.11.1989 US 443998**

(43) Date of publication of application:
**07.10.1992 Bulletin 1992/41**

(73) Proprietor: **MOTOROLA, INC.**
**Schaumburg, IL 60196 (US)**

(72) Inventors:
• **BIRCHLER, Mark, Allen**
**Roselle, IL 60172 (US)**
• **JASPER, Steven, Charles**
**Hoffman Estates, IL 60195 (US)**

(74) Representative: **Dunlop, Hugh Christopher et al**
**Motorola,**
**European Intellectual Property,**
**Midpoint,**
**Alencon Link**
**Basingstoke, Hampshire RG21 7PL (GB)**

(56) References cited:
US-A- 4 128 848          US-A- 4 166 251
US-A- 4 524 389          US-A- 4 730 343
US-A- 4 821 120          US-A- 4 879 729

• **No further relevant documents disclosed**

Note: Within nine months from the publication of the mention of the grant of the European patent, any person may give
notice to the European Patent Office of opposition to the European patent granted. Notice of opposition shall be filed in
a written reasoned statement. It shall not be deemed to have been filed until the opposition fee has been paid. (Art.
99(1) European Patent Convention).

EP 0 506 708 B1

## Description

<u>Technical Field</u>

This invention relates generally to FM (frequency modulation) radio communication systems and in particular to FM radio systems based on digital signal processing (DSP) techniques, and is more particularly directed toward a method for cancelling random FM noise caused by undesired phase modulation of the transmitted signal induced by a fading transmission channel.

<u>Background of the Invention</u>

In order to more fully comprehend the problem with which the present invention is concerned, the concept of Rayleigh fading should be understood. Rayleigh fading refers to the rapid fluctuation in the magnitude and phase of a received signal resulting from multipath propagation. This Rayleigh-faded signal is most objectionable to a listener when the magnitude of the fade is large enough to cause a substantial momentary decrease in the received signal amplitude. This results in the listener hearing an objectionable burst of noise.

Rayleigh fading frequently occurs when a mobile radio user travels down a road, passing relatively close to nearby objects such as utility poles, buildings, and bridges, which results in field strength variations at the vehicle's mobile antenna. These changes in field strength cause corresponding fluctuations in the envelope of the received signal. Objectionable noise bursts and pops in the recovered audio that substantially coincide with envelope minima are characterised as random FM noise.

Prior art approaches to improving response to Rayleigh-faded signals have been largely analog in nature, requiring precious space within mobile radio units and leading to increased costs. Further, most such approaches are double-ended in nature, requiring that some form of signal processing be added to both mobile units and base units. One approach to improving receiver performance in a Rayleigh fading environment is to mute receiver audio during fading events. Although this technique effectively eliminates noise bursts and pops, there is the potential for loss of information and potential unintelligibility. Additionally, the technique described in the above-cited Application involves a mixing operation (multiplication of two or more signals), which can result in sub-audible imbedded signalling, such as tone-coded squelch or low-speed trunking data, being translated into the audible portion of the spectrum, causing an objectionable rumbling in receiver audio.

US -A- 4,166,251, discloses a system comprising a demodulator for demodulating an input FM signal which has been subjected to interference by another FM signal, an envelope detector for detecting the envelope of fluctuation of the amplitude of the input signal, an AGC circuit for controlling the level of the input signal supplied to the envelope detector, a capacitor for passing only the AC component of the output of the envelope detector, a circuit having a transfer characteristic of a hyperbolic function and converting the waveform of the AC component, an analog multiplier supplied at its "x" input terminal with an output of the waveform converting circuit and producing a distortion cancellation signal, a first operation circuit supplied with the output signal of the demodulator and with the distortion cancellation signal and carrying out an operation such as substantially cancelling the interference distortion of the demodulated signal with the distortion cancellation signal, a delay circuit for delaying the output signal of the first operation circuit or of the demodulator by a specific time, and a second operation circuit supplied with the output signal of the first operation circuit or of the demodulator and with the output signal of the delay circuit, thereby carrying out a signal combining operation and supplying the resulting output signal to the "y" input terminal of the analog multiplier. The output of the first operation circuit is a demodulated signal in which the interference distortion has been cancelled and thus removed.

Accordingly, a need arises for a method for cancelling random FM noise that takes advantage of modern DSP (digital signal processor) techniques in order to save space and eliminate the expense of analog components. In addition, a technique is needed that counteracts the effects of a fading event, rather than muting the audio.

<u>Summary of Invention</u>

In accordance with the present invention, a method is provided for cancelling random FM noise that substantially eliminates discriminator output noise pulses, the method being substantially in accordance with claim 1 herein described.

<u>Brief Description of the Drawings</u>

Fig. 1 shows the real an imaginary parts, and the resultant magnitude, of a two ray adding parameter;
Fig 2 illustrates the real and imaginary parts, and the resultant magnitude, of a Rayleigh fading parameter;
Fig. 3 depicts the normalized derivative of a fade envelope around an envelope minimum;
Fig. 4 illustrates the relationship between the normalized envelope derivative and the discriminator output for Rayleigh fading;
Fig. 5 is a block diagram of the random FM noise cancellation algorithm of the present invention; and
Fig. 6 shows counter pulses and noise pulses properly aligned for summation to result in noise pulse cancellation.

## Detailed Description of the Invention

A faded FM signal can be modeled by the following equation:

$$f(t) = r(t)s(t)$$

where:

$s(t) = \quad e^{j\theta(t)}$ is the desired FM signal, and
$r(t) = \quad \rho(t)e^{j\varphi(t)}$ is the fading parameter.

Thus, the received signal can be expressed as:

$$f(t) = \rho(t)e^{j[\theta(t)+\varphi(t)]}$$

If this signal is applied to an FM limiter/discriminator, the resulting output is:

$$d(t) = \theta'(t) + \varphi'(t)$$

where:

$\theta'(t) = \quad \dfrac{d}{dt}\{\theta(t)\}$ is the desired message signal,

and

$\varphi'(t) = \quad \dfrac{d}{dt}\{\varphi(t)\}$ is the Random FM noise signal
$\quad = P(t).$

During deep fades, $P(t)$ contributes pulse-like noise to the desired signal. If these pulses are of a substantial amplitude with respect to the desired signal, and contain energy in the audio bandwidth (300 to 3000 Hz), they can cause significant degradation of audio quality.

The random FM noise cancellation method of the present invention uses information contained in the fading envelope ($\rho(t)$) to effectively cancel random FM noise pulses at the discriminator output. The pulse amplitude and shape are obtained from the envelope, while the pulse direction (sign) is obtained by proper filtering of the discriminator output signal.

The effectiveness of the instant invention hinges on the assumption that the real and imaginary parts of the fading parameter are approximately linear for the duration of the noise pulses. The fading parameter has previously been defined, in exponential form, as:

$$r(t) = \rho(t)e^{j\varphi(t)}$$

In rectangular form, the fading parameter can be expressed as:

$$r(t) = x(t) + jy(t)$$

For the duration of the random FM noise pulse, $P(t)$, the real and imaginary parts of $r(t)$ are approximately linear. That is:

$$x(t) \approx m_x t + b_x$$

and

$$y(t) \approx m_y t + b_y$$

This assumption is entirely reasonable and defensible for two reasons. First, Rayleigh (or Rician, multipath, etc.) fading is a lowpass process. Thus, over time segments significantly smaller than the minimum time period of the process, the signal will be approximately linear. The objectionable noise pulses caused by fading generally have widths that are considerably less than the minimum period of the process. This linear assumption is especially valid during envelope minima, at which times the noise pulses are generated.

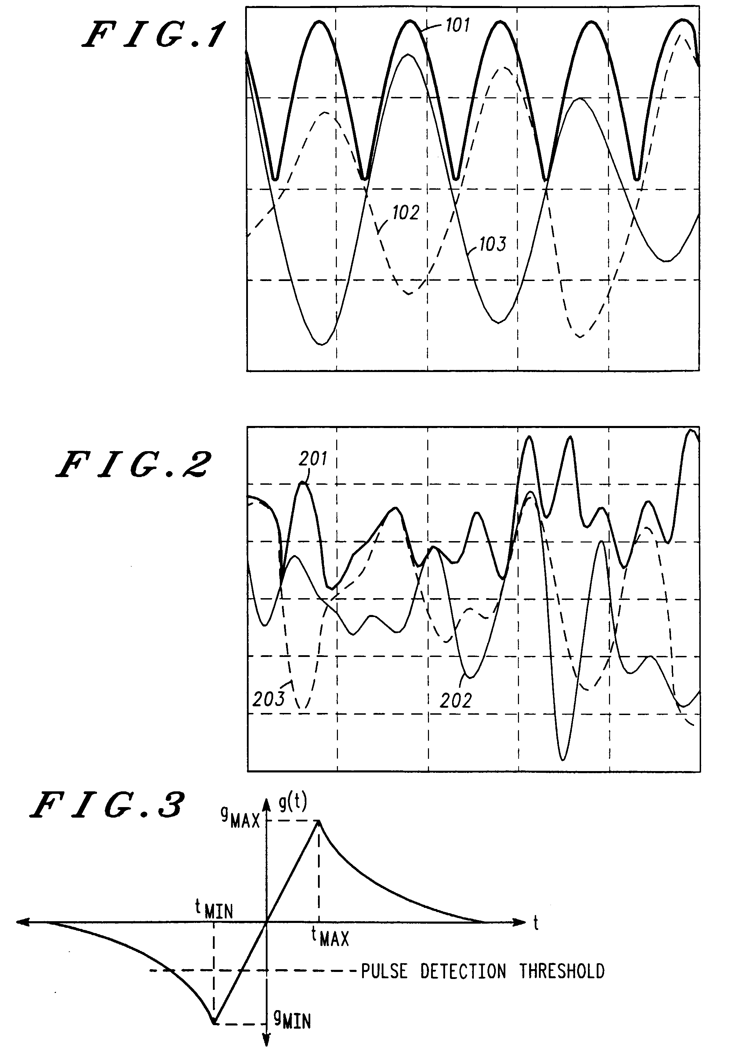

Fig. 1 illustrates the real part (102) and imaginary part (103) of a two ray fading parameter, as well as the resultant magnitude (101). A two ray fade consists of the direct reception of the desired signal plus one additional reflected signal, with the amplitudes of both signals remaining constant. As the Figure indicates, the real part (102) and imaginary part (103) of the fading parameter are the most linear during envelope minima.

Fig. 2 depicts the real part (202) and imaginary part (203) of a Rayleigh fading parameter and the resultant magnitude (201). Although the effect is less obvious with a Rayleigh fading parameter than with a two ray fade, the real part (202) and imaginary part (203) are still most likely to be linear around the envelope minima as the Figure shows.

It can be shown that, given this linear assumption, the amplitude and shape of the random FM noise pulse at the discriminator output can be calculated using only information contained in the fade envelope. Although this result is true in general, the derivation shown here will be for the simplified linear case in order to minimize algebraic complexity.

The fading parameter has been expressed previously, in rectangular form, as:

$$r(t) = x(t) + jy(t)$$

The magnitude and phase of the fading parameter are thus given by:

$$\rho(t) = \sqrt{x^2(t) + y^2(t)}$$

and

$$\varphi(t) = \tan^{-1}\left[\frac{y(t)}{x(t)}\right]$$

Assume a fade of the form:

$x(t) = \quad b \qquad$ (where b is a constant $\neq 0$)
$y(t) = \quad mt \qquad$ (where m is a constant slope $\neq 0$)

If $r(t)$ is input to a limiter/discriminator for FM demodulation, then the output will be given by:

$$P(t) = \frac{x(t)y'(t) - x'(t)y(t)}{x^2(t) + y^2(t)}$$

$$= \frac{mb}{\rho^2(t)}$$

$P(t)$ is maximum for $t = t_m = 0$, or the minimum of $\rho^2(t)$. Thus, $P_{max}$ can be defined as follows:

$$P_{max} = \frac{mb}{\rho^2(t_m)}$$

$$= \frac{m}{b}$$

The envelope of this fade is given by:

$$\rho(t) = \sqrt{m^2 t^2 + b^2}$$

Then the derivative of $\rho(t)$ with respect to time, $\rho'(t)$, is given by:

$$\rho'(t) = \frac{m^2 t}{\rho(t)}$$

The normalized derivative of $\rho(t)$ is defined as:

$$g(t) = \frac{\rho'(t)}{\rho(t)}$$

$$= \frac{m^2 t}{\rho^2(t)}$$

$$= \frac{m^2 t}{m^2 t^2 + b^2}$$

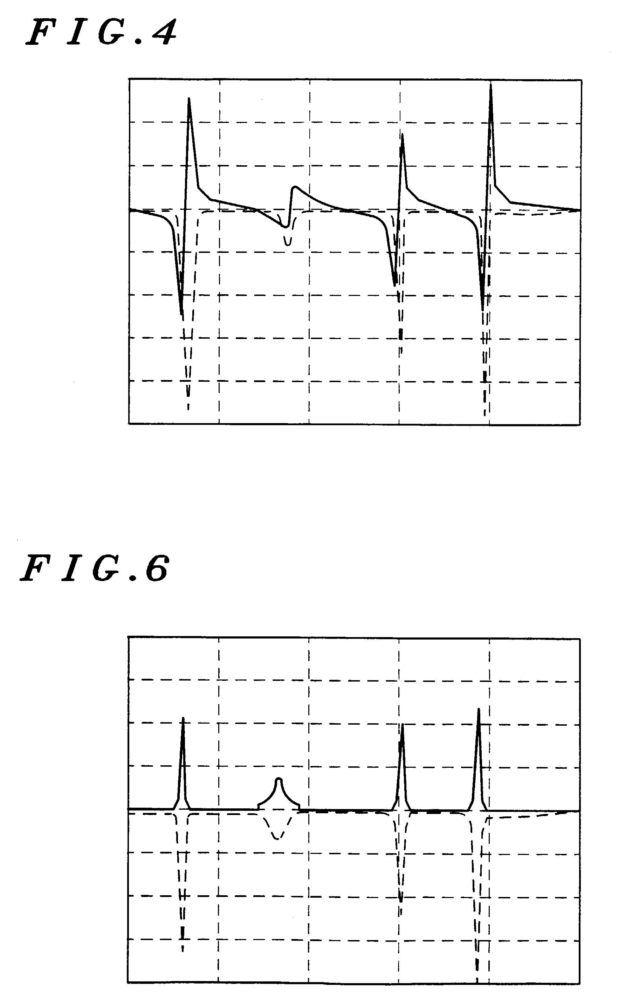

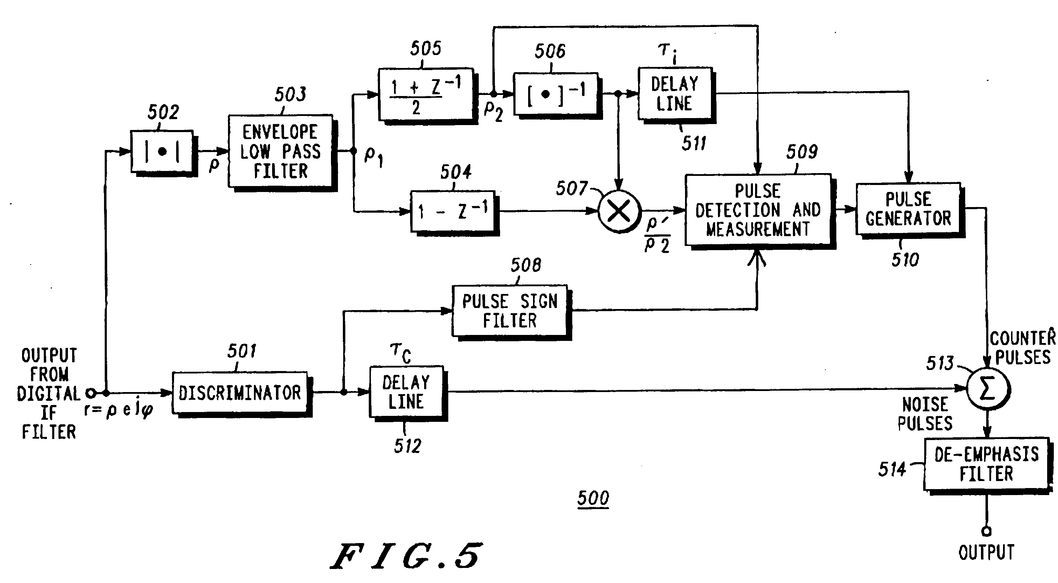

Fig. 3 is a plot of $g(t)$ around the envelope minimum.

It can be shown that the magnitude of the random FM noise signal ($|P_{max}|$) is simply the peak-to-peak amplitude of the normalized derivative. That is:

$$|P_{max}| = g_{max} - g_{min}$$

From Fig. 3 it can be seen that $g_{max} = g(t_{max})$ and $g_{min} = g(t_{min})$. These maximum and minimum times can be found using elementary calculus, since the solutions of $g'(t) - 0$ will give $t_{max}$ and $t_{min}$:

$$g'(t) = \frac{m^4 t^2 + m^2 b^2 - 2m^4 t^2}{\rho^4(t)} = 0$$

Since $\rho(t)$ has been defined such that it is never equal to zero, the solution to this equation is given by:

$$m^4 t^2 = m^2 b^2$$

or:

$$t = \pm \left| \frac{b}{m} \right|$$

Therefore:

$$t_{max} = \left| \frac{b}{m} \right|$$

and

$$t_{min} = - \left| \frac{b}{m} \right|$$

Substituting these values back into $g(t)$ gives $g_{max}$ and $g_{min}$:

$$g_{max} = g\left( \left| \frac{b}{m} \right| \right) = \left| \frac{m}{2b} \right|$$

$$g_{min} = g\left( - \left| \frac{b}{m} \right| \right) = - \left| \frac{m}{2b} \right|$$

Finally:

$$|P_{max}| = \left| \frac{m}{b} \right| = g_{max} - g_{min}$$

This relationship also holds for the general case:

$$x(t) = m_x t + b_x$$

$$y(t) = m_y t + b_y$$

For the case of Rayleigh fading, Fig. 4 shows noise pulses at the discriminator output by a dashed line, with the normalized envelope derivative depicted by a solid line. From an examination of the Figure, it is apparent that the noise pulse magnitude is equal to the peak-to-peak value of the normalized derivative.

The signal at the output of an FM limiter/discriminator in response to the general linear fade expressed above is:

$$P(t) = \frac{b_x m_y - b_y m_x}{\rho^2(t)}$$

$$= \frac{k}{\rho^2(t)}$$

(where $k$ is a constant).
It has already been demonstrated that:

$$|P_{max}| = \frac{|k|}{\rho^2(t_m)} = g_{max} - g_{min}$$

Since $\rho(t)$ is known, as well as $|P_{max}|$, $|k|$ can be found by:

$$|k| = |P_{max}| \rho^2(t_m)$$

$$= [g_{max} - g_{min}] \rho^2(t_m)$$

Thus, the absolute value of the entire discriminator output noise pulse can be reproduced both in amplitude and shape using only information contained in the fade envelope:

$$|P(t)| = \frac{[g_{max} - g_{min}] \rho^2(t_m)}{\rho^2(t)}$$

In order to effectively cancel the noise pulse at the discriminator output, only the direction of the noise pulse remains to be determined. Pulse direction can be detected by proper filtering of the discriminator output signal. If no sub-audible signaling is present, such as coded squelch or low-speed trunking data, the pulse direction can be detected via a low pass filter. In the case of sub-audible signaling, a properly designed low pass or band pass filter will serve to determine pulse direction. In some instances (i.e., where the bandwidth of the message signal is lowpass), a high pass filter may be employed to determine pulse direction.

A block diagram of the preferred implementation of the method of the present invention is shown in Fig. 5, as generally depicted by the number 500. Since the method is designed for use in a digitally implemented radio, the noise cancellation algorithm is implemented using a DSP, preferably a DSP56000 family device manufactured by Motorola, Inc.

The algorithm receives its input from a digital IF filter, in the form of a sequence of complex samples, at the input of the discriminator (501). The algorithm necessarily runs at the discriminator sampling rate.

The magnitude of each complex sample at the discriminator is calculated in block 502. These magnitude samples constitute the raw envelope (p) of the received signal. This envelope signal is then filtered by the envelope low pass filter (LPF) (503). The envelope LPF (503) is required to reduce the effects of noise and IF filter-induced ripple on the envelope. Since a filter introduces a delay to the calculation performed by the algorithm, the envelope LPF (503) is preferably linear phase and symmetric in order that the delay introduced will be an integral number of sample periods. Restricting filter delay to an integral number of sample periods simplifies alignment of generated counter pulses with actual noise pulses, which will be discussed in more detail below. The envelope LPF is implemented in the DSP as a symmetric finite impulse response (FIR) filter with an odd number of taps.

The output of the envelope LPF (503), designated in Fig. 5 as $p_1$, is processed via two parallel paths. In the lower path, the derivative of $p_1$ is calculated in differentiation block 504. The expression appearing within block 504, 1 $z^{-1}$, is one possible z-transform approximation of differentiation, as is known in the art, and introduces a delay of one-half a sample period.

In order to compensate for this one-half sample period delay, the upper path includes a two-tap filter (505) that adds a one-half sample period delay. The expression $[1 + z^{-1}]/2$ is one possible z-transform implementation of an appropriate delay process. The delayed envelope is subjected to an inversion operation (506), then the envelope derivative and the inverted envelope are multiplied in block 507 to yield the normalized derivative.

The sign of the counter pulse is estimated by a pulse sign filter (508) that uses, as input, the output of the discriminator (501). The filter must be designed such that its passband covers a frequency region which contains minimal energy from normal audio, and any subaudible signaling, while maximizing noise pulse energy. Since random FM noise pulses are lowpass in nature, the sign filter passband must reside in some frequency region below the normal audio cutoff frequency of 300 Hz.

The impulse response of the sign filter should be short, with only one dominant lobe, in order to minimize inter noise pulse interference. Noise pulses that are bad enough to necessitate cancellation look essentially like impulses to the sign filter. Thus, the sign estimation delay from the detected pulse center is equal to the delay to the maximum amplitude excursion of the filter's impulse response.

The normalized derivative computed in block 507 of Fig. 5 triggers the algorithm to begin collecting data for the creation of the counter pulse when it crosses the pulse detection threshold indicated in Fig. 3. Although data collection is triggered by the normalized derivative crossing a minimum threshold in the preferred embodiment, data collection could also be initiated through the normalized derivative crossing a maximum threshold, or the absolute value of the normalized derivative exceeding a predetermined threshold value. The pulse detection and measurement block (509) detects this threshold crossing, and begins searching for the local minimum of g(t) ($g_{min}$) between the threshold crossing and the zero crossing. The local maximum ($g_{max}$) is then located, and the absolute value of the pulse amplitude is calculated as described above. The output of the pulse sign filter (508) yields a sign estimate.

All that remains is the pulse shape. As discussed above with reference to the derivation for the general case, the pulse shape is determined by the square of the ratio of the envelope value at the pulse center ($\rho(t_m)$) to the envelope amplitude around the fade event ($\rho(t)$). The envelope amplitude value at the pulse center is determined from the delayed envelope passed to the pulse detection and measurement block (509) from delay process 505. The final pulse shape determination is made in the pulse generator block (510) through multiplication by properly delayed (by $\tau_i$) samples of the inverse envelope provided by a delay line (511). The pulse detection and measurement block (509) provides the necessary information regarding pulse amplitude and sign to the pulse generator (510). Since the algorithm is implemented in a DSP, the delays introduced by each individual process are known exactly, so it is a simple matter to compute $\tau_i$ to ensure that inverse envelope information will be delayed by the appropriate amount such that counter pulses will coincide properly with noise pulses at the discriminator output.

The output of the discriminator (501) is also input to a delay line (512) of length $\tau_c$, where $\tau_c$ denotes the cancellation delay. The cancellation delay represents the minimum audio delay necessary for the algorithm to operate correctly, and thus must be known exactly as well. The noise pulses at the output of the delay line (512) and the properly aligned counter pulses from the pulse generator (510) are added together in a summer (513) before being processed by a simple de-emphasis filter (514) to yield the final audio output. Fig. 6 depicts counter pulses (solid line) and noise pulses (dashed line) properly aligned for noise cancellation.

Because proper operation of the noise cancellation algorithm of the present invention is highly dependent upon an accurate characterization of the envelope of the received signal, some modifications of the algorithm are necessary under operating conditions that tend to cause corruption of envelope data. These adverse operating conditions include low signal-to-noise (S/N) ratio, adjacent channel or co-channel interference, and frequency selective fading.

Under good operating conditions, the normalized derivative, as depicted in Fig. 3, will have only one zero crossing during the collection period. However, at low S/N, the normalized derivative becomes a function of noise in addition to the desired envelope signal. Under these conditions, the normalized derivative will have significantly more zero crossings. Additional extraneous zero crossing events are also caused by high frequency envelope ripple due to interference or frequency selective fading. Accordingly, whenever a second zero crossing occurs unexpectedly within a predetermined time after the initial zero crossing, data collection is disabled and the algorithm is reset.

Computer simulation of Rayleigh fading has shown that random FM noise pulses virtually never achieve amplitudes greater than 2 radians. Thus, whenever $|g_{max}|$ or $|g_{min}|$ exceeds the value of 1.0, something is probably wrong. In response to this error condition, the pulse amplitude estimate produced by the algorithm is set to zero, so that a counter pulse of amplitude zero is added to the discriminator output.

A third possible error condition may occur during computation of the shape of the counter pulse. As described above, the shape is the square of the ratio of the envelope minimum to the amplitude of envelope samples around the noise pulse event. This ratio should always be less than or equal to one, since the envelope minimum itself is the local minimum of envelope sample amplitudes around the noise pulse event. If this ratio is greater than one, an error has occurred, and the pulse amplitude estimate is set to zero to prevent a non-zero counter pulse from being added to the discriminator output.

**Claims**

1. For an FM modulated RF signal having an envelope, a method for cancellation of random FM noise that substantially eliminates discriminator output noise pulses, the method comprising the steps of:

> (a) processing (502, 503, 504, 505, 506, 507, 509, 510, 511) the envelope of the FM modulated signal to determine characteristics indicative of shape, amplitude, and time of occurrence of noise pulses, wherein the step (a) of processing the envelope of the FM modulated signal further comprises the steps of, (a1) differentiating (504) the envelope to provide an envelope derivative, (a2) dividing (507) the envelope derivative by the envelope to yield a normalised derivative, (a3) computing (509) peak-to-peak amplitude of the normalised derivative to provide noise pulse amplitude, (a4) computing (509) time of occurrence of envelope minima to provide time of occurrence of noise pulses and (a5) computing (509) the square of the ratio of envelope amplitude at envelope minima to envelope amplitude around envelope minima to provide noise pulse shape;
>
> (b) processing (508, 509) the discriminator output signal to determine at least one characteristic indicative of direction of the noise pulses;
>
> (c) generating (510) counter-pulses based upon the characteristics determined in steps (a) and (b) and
>
> (d) combining (513) the counter-pulses and the discriminator output to substantially cancel the random FM noise pulses.

2. The method in accordance with claim 1, wherein processing steps (a3) through (a5) are executed only when the amplitude of the normalised derivative crosses a predetermined threshold.

3. The method in accordance with claim 1, wherein processing steps (a3) through (a5) are terminated when the normalised derivative has more than one zero crossing within a predetermined time.

4. The method in accordance with claim 1, wherein the step (b) of processing the discriminator output signal further comprises the steps of:

> (b1) filtering (508) the discriminator output signal to provide a filtered signal; and
> (b2) sampling (509) the filtered signal to provide noise pulse direction.

5. The method in accordance with claim 4, wherein the filtered signal is sampled at a time substantially coincident with the maximum amplitude excursion of the filter's impulse response.

6. The method in accordance with claim 1, wherein the step (d) of combining the counter pulses and the discriminator output comprises adding (513) the counter pulses and the discriminator output.

7. For an FM modulated RF signal having an envelope, an apparatus for cancellation of random FM noise that substantially eliminates discriminator output noise pulses, the apparatus comprising:

> means for processing (502, 503, 504, 505, 506, 507, 509, 510, 511) the envelope of the FM modulated signal to determine first characteristics indicative of shape, amplitude, and time of occurrence of noise pulses, wherein the means for processing the envelope of the FM modulated signal further comprises means for differentiating (504) the envelope to provide an envelope derivative, means for dividing (507) the envelope derivative by the envelope to yield a normalised derivative, means for computing (509) peak-to-peak amplitude of the normalised derivative to provide noise pulse amplitude, means for computing (509) time of occurrence of envelope minima to provide time of occurrence of noise pulses, means for computing (509) the square of the ratio of envelope amplitude at envelope minima to envelope amplitude around envelope minima to provide noise pulse shape;

means for processing (508, 509) the discriminator output signal to determine at least one second characteristic indicative of direction of the noise pulses;

means for generating (510) counter-pulses based upon the first and second characteristics;

means for combining (513) the counter-pulses and the discriminator output to substantially cancel the random FM noise pulses.

8. The apparatus in accordance with claim 7, wherein the means for processing the discriminator output signal further comprises:

means for filtering (508) the discriminator output signal to provide a filtered signal;
means for sampling (509) the filtered signal to provide noise pulse direction.

**Patentansprüche**

1. Verfahren zum Unterdrücken von statistischem FM-Rauschen für ein FM-moduliertes HF-Signal mit einer Hüllkurve, das Rauschimpulse am Ausgang eines Diskriminators im wesentlichen beseitigt, wobei das Verfahren die folgenden Schritte umfaßt:

(a) Verarbeiten (502, 503, 504, 505, 506, 507, 509, 510, 511) der Hüllkurve des FM-modulierten Signals, um Eigenschaften zu bestimmen, die Form, Amplitude und Zeit des Auftretens von Rauschimpulsen anzeigen, wobei der Schritt (a) der Verarbeitung der Hüllkurve des FM-modulierten Signals weiter die folgenden Schritte umfaßt: (a1) Differenzieren (504) der Hüllkurve, um eine Hüllkurvenableitung zu gewinnen, (a2) Teilen (507) der Hüllkurvenableitung durch die Hüllkurve, um eine normalisierte Ableitung hervorzubringen, (a3) Berechnen (509) der Spitze-Spizte-Amplitude der normalisierten Ableitung, um die Rauschimpulsamplitude zu gewinnen, (a4) Berechnen (509) der Zeit des Auftretens von Hüllkurvenminima, um die Zeit des Auftretens von Rauschimpulsen zu gewinnen, und (a5) Berechnen (509) des Quadrates des Verhältnisses der Hüllkurvenamplitude bei Hüllkurvenminima zu der Hüllkurvenamplitude um Hüllkurvenminima, um die Rauschimpulsform zu gewinnen;

(b) Verarbeiten (508, 509) des Diskriminatorausgangssignals, um wenigstens eine Eigenschaft zu bestimmen, die die Richtung des Rauschimpulses anzeigt;

(c) Erzeugen (510) von Gegenimpulsen auf der Grundlage der in den Schritten (a) und (b) bestimmten Eigenschaften und

(d) Kombinieren (513) der Gegenimpulse und des Diskriminatorausgangs, um die statistischen FM-Rauschimpulse im wesentlichen zu unterdrücken.

2. Verfahren nach Anspruch 1, bei dem die Verarbeitungsschritte (a3) bis (a5) nur ausgeführt werden, wenn die Amplitude der normalisierten Ableitung eine vorbestimmte Schwelle kreuzt.

3. Verfahren nach Anspruch 1, bei dem die Verarbeitungsschritte (a3) bis (a5) beendet werden, wenn die normalisierte Ableitung mehr als einen Nulldurchgang innerhalb einer vorbestimmten Zeit aufweist.

4. Verfahren nach Anspruch 1, bei dem der Schritt (b) der Verarbeitung des Diskriminatorausgangssignals weiter die Schritte umfaßt:

(b1) Filtern (508) des Diskriminatorausgangssignals, um ein gefiltertes Signal zu gewinnen, und

(b2) Abtasten (509) des gefilterten Signals, um die Rauschimpulsrichtung zu gewinnen.

5. Verfahren nach Anspruch 4, bei dem das gefilterte Signal bei einer Zeit abgetastet wird, die im wesentlichen mit dem maximalen Amplitudenausschlag des Impulsansprechens des Filters zusammenfällt.

6. Verfahren nach Anspruch 1, bei dem der Schritt (d) des Kombinierens der Gegenimpulse und des Diskriminatorausgangs das Addieren (513) der Gegenimpulse und des Diskriminatorausgangs umfaßt.

7. Vorrichtung zum Unterdrücken von statistischem FM-Rauschen für ein FM-moduliertes HF-Signal mit einer Hüllkurve, die Rauschimpulse am Ausgang eines Diskriminators im wesentlichen beseitigt, wobei die Vorrichtung umfaßt:

eine Einrichtung zum Verarbeiten (502, 503, 504, 505, 506, 507, 509, 510, 511) der Hüllkurve des FM-modulierten Signals, um erste Eigenschaften zu bestimmen, die Form, Amplitude und Zeit des Auftretens von Rauschimpulsen anzeigen, wobei die Einrichtung zum Verarbeitung der Hüllkurve des FM-modulierten Signals weiter eine Einrichtung zum Differenzieren (504) der Hüllkurve, um eine Hüllkurvenableitung zu gewinnen, eine Einrichtung zum Teilen (507) der Hüllkurvenableitung durch die Hüllkurve, um eine normalisierte Ableitung hervorzubringen, eine Einrichtung zum Berechnen (509) der Spitze-Spizte-Amplitude der normalisierten Ableitung, um die Rauschimpulsamplitude zu gewinnen, eine Einrichtung zum Berechnen (509) der Zeit des Auftretens von Hüllkurvenminima, um die Zeit des Auftretens von Rauschimpulsen zu gewinnen, sowie eine Einrichtung zum Berechnen (509) des Quadrates des Verhältnisses der Hüllkurvenamplitude bei Hüllkurvenminima zu der Hüllkurvenamplitude um Hüllkurvenminima, umfaßt, um die Rauschimpulsform zu gewinnen;

eine Einrichtung zum Verarbeiten (508, 509) des Diskriminatorausgangssignals, um wenigstens eine zweite Eigenschaft zu bestimmen, die die Richtung der Rauschimpulse anzeigt;

eine Einrichtung zum Erzeugen (510) von Gegenimpulsen auf der Grundlage der ersten und zweiten Eigenschaften;

eine Einrichtung zum Kombinieren (513) der Gegenimpulse und des Diskriminatorausgangs, um die statistischen FM-Rauschimpulse im wesentlichen zu unterdrücken.

8. Vorrichtung nach Anspruch 7, bei der die Einrichtung zum Verarbeiten des Diskriminatorausgangssignals weiter umfaßt:

eine Einrichtung zum Filtern (508) des Diskriminatorausgangssignals, um ein gefiltertes Signal zu gewinnen;

eine Einrichtung zum Abtasten (509) des gefilterten Signals, um die Rauschimpulsrichtung zu gewinnen.

## Revendications

1. Procédé, pour un signal à haute fréquence modulé FM (en modulation de fréquence) comportant une enveloppe, de suppression du bruit FM aléatoire, qui élimine sensiblement les impulsions de bruit à la sortie de discriminateur, le procédé comprenant les étapes :

(a) de traitement (502, 503, 504, 505, 506, 507, 509, 510, 511) de l'enveloppe du signal modulé FM pour déterminer des caractéristiques indicatives de forme, d'amplitude et d'instant d'occurrence d'impulsion de bruit, l'étape (a) de traitement d'enveloppe du signal modulé FM comprenant en outre les étapes : (a1) de différentiation (504) de l'enveloppe pour donner une dérivée d'enveloppe ; (a2) de division (507) de la dérivée d'enveloppe par l'enveloppe pour donner une dérivée normalisée ; (a3) de calcul (509) d'amplitude de crête à crête de la dérivée normalisée pour donner l'amplitude d'impulsion de bruit ; (a4) de calcul (509) de l'instant d'occurrence de minima d'enveloppe pour donner l'instant d'occurrence d'impulsions de bruit ; et (a5) de calcul (509) du carré du rapport de l'amplitude d'enveloppe au droit des minima d'enveloppe à l'amplitude d'enveloppe autour des minima d'enveloppe pour donner la forme des impulsions de bruit ;
(b) de traitement (508, 509) du signal de sortie de discriminateur pour déterminer au moins une caractéristique indicative du sens des impulsions de bruit;
(c) de production (510) d'anti-impulsions basées sur les caractéristiques déterminées aux étapes (a) et (b) ; et
(d) de combinaison (513) des anti-impulsions et de la sortie de discriminateur pour supprimer sensiblement les impulsions de bruit FM aléatoires.

2. Procédé selon la revendication 1, dans lequel les étapes de traitement (a3) à (a5) s'exécutent seulement lorsque l'amplitude de la dérivée normalisée coupe un seuil prédéterminé.

3. Procédé selon la revendication 1, dans lequel les étapes de traitement (a3) à (a5) se terminent lorsque la dérivée normalisée a plus d'un passage au zéro dans un temps prédéterminé.

4. Procédé selon la revendication 1, dans lequel l'étape (b) de traitement du signal de sortie de discriminateur comprend, en outre, les étapes :

(b1) de filtrage (508) du signal de sortie de discriminateur pour fournir un signal filtré ; et

(b2) d'échantillonnage (509) du signal filtré pour fournir le sens d'impulsion de bruit.

5. Procédé selon la revendication 4, dans lequel le signal filtré est échantillonné à un instant qui coïncide sensiblement avec l'excursion d'amplitude maximale de la réponse impulsionnelle de filtre.

6. Procédé selon la revendication 1, dans lequel l'étape (d) de combinaison des anti-impulsions et de la sortie de discriminateur comprend l'addition (513) des anti-impulsions et de la sortie de discriminateur.

7. Dispositif, pour un signal à haute fréquence modulé FM comportant une enveloppe, de suppression du bruit FM aléatoire, qui élimine sensiblement les impulsions de bruit à la sortie de discriminateur, le dispositif comprenant ;

un moyen de traitement (502, 503, 504, 505, 506, 507, 509, 510, 511) pour traiter l'enveloppe du signal modulé FM pour déterminer des premières caractéristiques indicatives de forme, d'amplitude et d'instant d'occurrence d'impulsion de bruit, le moyen de traitement de l'enveloppe du signal modulé FM comprenant en outre un moyen de différentiation (504) de l'enveloppe pour donner une dérivée d'enveloppe ; un moyen de division (507) de la dérivée d'enveloppe par l'enveloppe pour donner une dérivée normalisée ; un moyen de calcul (509) d'amplitude de crête à crête de la dérivée normalisée pour donner l'amplitude d'impulsion de bruit ; un moyen de calcul (509) de l'instant d'occurrence des minima d'enveloppe pour donner l'instant d'occurrence d'impulsions de bruit ; et un moyen de calcul (509) du carré du rapport de l'amplitude d'enveloppe au droit des minima d'enveloppe à l'amplitude d'enveloppe autour des minima d'enveloppe pour donner la forme des impulsions de bruit ;
un moyen de traitement (508, 509) du signal de sortie de discriminateur pour déterminer au moins une seconde caractéristique indicative du sens des impulsions de bruit ;
un moyen générateur (510) pour produire des anti-impulsions basées sur les premières et seconde caractéristiques ;
un moyen de combinaison (513) pour combiner les anti-impulsions et de la sortie de discriminateur pour supprimer sensiblement les impulsions de bruit FM aléatoires.

8. Dispositif selon la revendication 7, dans lequel le moyen de traitement du signal de sortie de discriminateur comprend, en outre, un moyen de filtrage (508) pour filtrer le signal de sortie de discriminateur pour fournir un signal filtré ; et

un moyen d'échantillonnage (509) pour échantillonner le signal filtré pour donner le sens d'impulsion de bruit.

*FIG.1*

*FIG.2*

*FIG.3*

# FIG.4

# FIG.6

*FIG.5*

500